Europäisches Patentamt

European Patent Office

Office européen des brevets

(19)

(11) Publication number: **0 007 730**
**B1**

# EUROPEAN PATENT SPECIFICATION

(45) Date of publication of patent specification: **14.07.82**

(51) Int. Cl.³: **H 01 S 3/19, H 01 L 33/00**

(21) Application number: **79301331.9**

(22) Date of filing: **09.07.79**

(54) Semiconductor laser device.

(30) Priority: **10.07.78 JP 83014/78**

(43) Date of publication of application:
**06.02.80 Bulletin 80/3**

(45) Publication of the grant of the patent:
**14.07.82 Bulletin 82/28**

(84) Designated Contracting States:
**DE FR GB NL**

(56) References cited:
**US - A - 4 023 062**

**IEEE JOURNAL OF QUANTUM ELECTRONICS,
vol. QE—13, no. 8, August 1977, pages
637—642 New York, U.S.A.
P. D. WRIGHT et al.: "Near-infrared In 1-x-
GaxP1-zAsz Double-Hetero-junction Lasers:
Constant-Temperature LPE Growth and
Operation in an External-Grating Cavity"**

(73) Proprietor: **Hitachi, Ltd.
5-1, Marunouchi 1-chome
Chiyoda-ku Tokyo 100 (JP)**

(72) Inventor: **Kajimura, Takashi
2-32 Koyasu-cho
Hachioji-shi, Tokyo (JP)**
Inventor: **Hirao, Motohisa
2-2-6 Ogikubo
Suginami-ku, Tokyo (JP)**
Inventor: **Nakamura, Michiharu
2196-283 Hirai
Hinodemachi, Nishitama-gun, Tokyo (JP)**
Inventor: **Kuroda, Takao
4-815-2 Nishi-koigakubo
Kokubunji-shi, Tokyo (JP)**
Inventor: **Yamashita, Shigeo
1-48-18 Akatsuki-cho
Hachioji-shi, Tokyo (JP)**
Inventor: **Umeda, Junichi
612-10 Kamiichibukata-machi
Hachioji-shi, Tokyo (JP)**

(74) Representative: **Paget, Hugh Charles Edward et al,
MEWBURN ELLIS & CO. 2/3 Cursitor Street
London EC4A 1BQ (GB)**

Courier Press, Leamington Spa, England.

# 0 007 730

## Semiconductor laser device

The present invention relates to a semiconductor laser device comprising a semiconductor substrate and above the substrate a semiconductor active layer and semiconductor cladding layers.

Semiconductor laser devices are seen as being useful in practice as small-size high-efficiency light sources, and as such preferable to conventional He-Ne gas laser devices in the field of optical information processing devices, video disks and the like.

Typical examples of semiconductor laser devices proposed hitherto and having the double-hetero structure are as follows.

(1)  A device using GaAlAs as active layer and cladding layer, see, for example, I. Landany and H. Kressel in 1976 IEDM Technical Digest.

(2)  A device using GaAsP as active layer and GaInP as cladding layer, see, for example, H. Kressel et al. in Applied Physics Letters, Vol. 30, No. 5, 1977, pages 249—251.

The known device (1) has an oscillation wavelength above 710 nm in continuous oscillation at room temperature, while the known device (2) has an oscillation wavelength above 700 nm also in continuous oscillation at room temperature. Continuous oscillation at room temperature has not been achieved at wavelengths below the above critical levels, because in order to obtain oscillation in practice, it is necessary that the band gap of the active layer should be sufficiently smaller than that of the cladding layer and that a direct transition area is formed.

It is therefore a primary object of the present invention to provide a semiconductor laser device suitable for operating at a shorter oscillation wavelength.

The invention as claimed is intended to achieve this object. It provides a semiconductor laser device having a double-hetero structure with a particular combination of semiconductor materials. In some devices of the present invention, continuous oscillation can be performed at an oscillation wavelength of the order of 0.6 $\mu$m.

The regions where laser oscillation or optical modulation is carried out, that is the cladding layers disposed above and below the active layer, have a lower refractivity and a larger band gap than in the active layer.

Embodiments of the invention will now be described by way of example with reference to the accompanying drawings, in which:—

Fig. 1 is a perspective view of a semiconductor laser device embodying the present invention;

Fig. 2 is a graph showing the relationship between the value of t in the $GaAs_tP_{1-t}$ crystal substrate and the amount y of Ga in the active layer, illustrating matching of lattice constants of the respective layers;

Figs. 3 to 7 are graphs showing the relation between the amount y of Ga in the active layer and the amount p of Ga in the cladding layer in five separate cases in which $GaAs_tP_{1-t}$ crystal forming the substrate has a value of t of 1, 0.98, 0.9, 0.75 or 0.6 respectively.

Fig. 8 is a graph showing the relation between the amount t of As in the substrate and the amount y of Ga in the active layer, for varying amounts p of Ga in the cladding layer;

Figs. 9 and 10 are respectively perspective views of second and third semiconductor laser devices embodying the present invention.

In this description and the claims, directional terms such as "above" and "side" are used purely for convenience. The devices may of course be operated in any desired orientation.

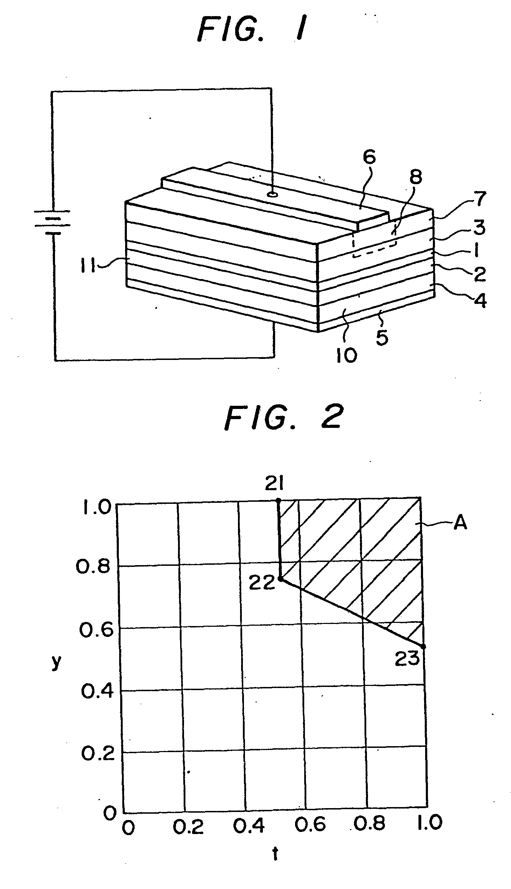

In the device of Fig. 1, the active layer 1 is composed of $Ga_yIn_{1-y}As_xP_{1-x}$ and the cladding layers 2 and 3 below and above the layer 1 are composed of $n\text{-}Ga_pAl_{1-p}As_qP_{1-q}$ and $p\text{-}Ga_{p'}Al_{1-p'}As_{q'}P_{1-q'}$ respectively. $GaAs_tP_{1-t}$ is used for the semiconductor substrate 4.

The device oscillates at room temperature when the compositions of the semiconductors are selected so that $0.52 \leqq y \leqq 1.0$, $0 \leqq x \leqq 1.0$, $0 \leqq p \leqq 0.91$, $0 \leqq p' \leqq 0.91$, $0.47 \leqq q \leqq 1.0$, $0.47 \leqq q' \leqq 1.0$ and $0.54 \leqq t < 1$.

With the combination of the materials satisfying the above requirements, each cladding layer can have a large band gap, and therefore the desired shortening of the oscillation wavelength can easily be obtained.

The compositions of the respective semiconductor layers will now be discussed in detail.

A crystal having the composition $GaAs_tP_{1-t}$ $(0.54 \leqq t < 1.0)$ is used for the semiconductor substrate 4.

It is essential that the lattice constants of the layers being formed as a laminate should adequately approximate to the lattice constant a of the semiconductor substrate 4. The lattice constant a of GaAs crystal is 5.653 Å.

If the amount y in the active layer 1 composed of $Ga_yIn_{1-y}As_xP_{1-x}$ is in the region A of Fig. 2, matching of the lattice constants of the respective layers becomes possible. When a GaAsP substrate is used, matching is possible in the region where $y_0 \leqq y \leqq 1$. ($y_0$ is the lower limit of y for a given value of t). The coordinates of points 21, 22 and 23 in Fig. 2 are given in Table 1.

2

TABLE 1

| Point | t | y |
|-------|------|-------|
| 21 | 0.54 | 1.0 |
| 22 | 0.54 | 0.74 |
| 23 | 1.0 | 0.525 |

The region A shown in Fig. 2 is a critical region where lattice matching of the respective layers is possible and the active layer is of the direct transition type.

The value x should satisfy the requirements represented by the following formulae, for matching of the lattice constants:

$$|x - x_0| \leq \Delta x \qquad (1)$$

and

$$x_0 = \frac{a - 5.87 + 0.42y}{0.18 + 0.02y} \qquad (2)$$

wherein a is the lattice constant of the substrate crystal.

In the above formulae, $\Delta x$ is an allowance for non-matching and empirically is up to 0.02. x is selected within the range 0 to 1.0.

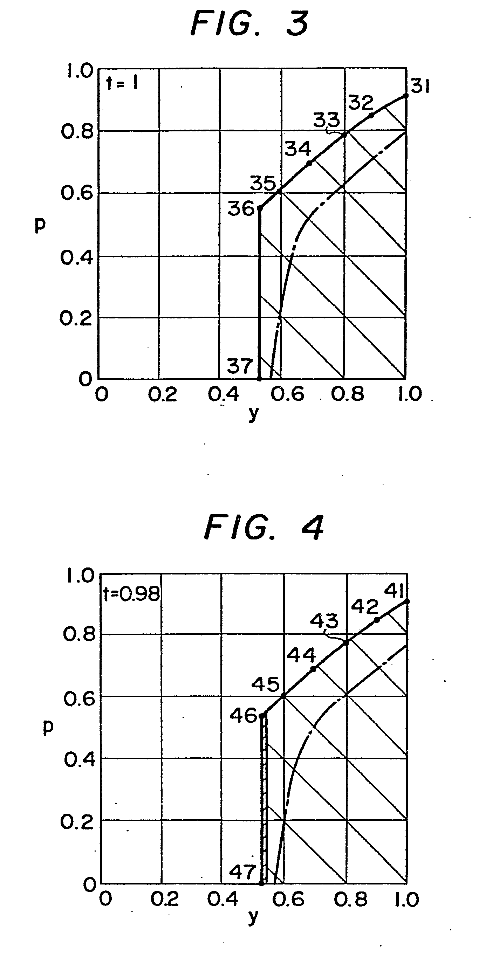

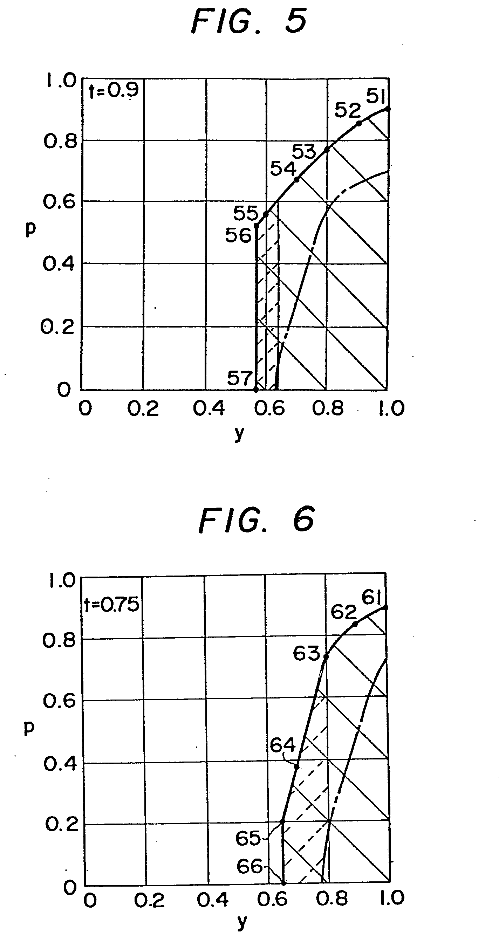

In the $Ga_pAl_{1-p}As_qP_{1-q}$ (or $Ga_{p'}Al_{1-p'}As_{q'}P_{1-q'}$) of the cladding layers, in order to achieve operation of the laser device at room temperature, the amount of Ga is within a range now to be described. The permissible region for p or p', depending on the amount y of Ga in the active layer 1, is shown by the hatched regions in Figs. 3 to 7, i.e. the whole area to the right of and below the heavy full line in each Figure. (In each Figure, p is indicated on the ordinate and p' can be taken to be similarly intended). Figs. 3, 4, 5, 6 and 7 show the relationships between y and p for $t = 1$, $t = 0.98$, $t = 0.9$, $t = 0.75$ and $t = 0.6$ respectively. In practice p and y for other values of t can be selected by interpolation from Figs. 3 to 7. In the regions of Figs. 3 to 7 defined by broken hatch lines (in Fig. 3 this region is only the line 36—37 and in Fig. 4 it is the narrow vertical region adjacent the line 46—47), oscillation at a wavelength $\lambda \leq 6470$ Å is possible.

The coordinates of the indicated points on the boundaries of the regions shown in Figs. 3 to 7 are given in Table 2.

# 0 007 730

TABLE 2

| | y | p | | y | p |
|---|---|---|---|---|---|
| 31 | 1.0 | 0.91 | 41 | 1.0 | 0.91 |
| 32 | 0.9 | 0.84 | 42 | 0.9 | 0.84 |
| 33 | 0.8 | 0.77 | 43 | 0.8 | 0.77 |
| 34 | 0.7 | 0.70 | 44 | 0.7 | 0.69 |
| 35 | 0.6 | 0.62 | 45 | 0.6 | 0.60 |
| 36 | 0.52 | 0.54 | 46 | 0.54 | 0.53 |
| 37 | 0.52 | 0 | 47 | 0.54 | 0 |
| 51 | 1.0 | 0.90 | 61 | 1.0 | 0.90 |
| 52 | 0.9 | 0.83 | 62 | 0.9 | 0.83 |
| 53 | 0.8 | 0.76 | 63 | 0.8 | 0.70 |
| 54 | 0.7 | 0.66 | 64 | 0.7 | 0.38 |
| 55 | 0.6 | 0.54 | 65 | 0.64 | 0.19 |
| 56 | 0.57 | 0.51 | 66 | 0.64 | 0 |
| 57 | 0.57 | 0 | | | |
| 71 | 1.0 | 0.82 | | | |
| 72 | 0.9 | 0.62 | | | |
| 73 | 0.8 | 0.36 | | | |
| 74 | 0.71 | 0 | | | |

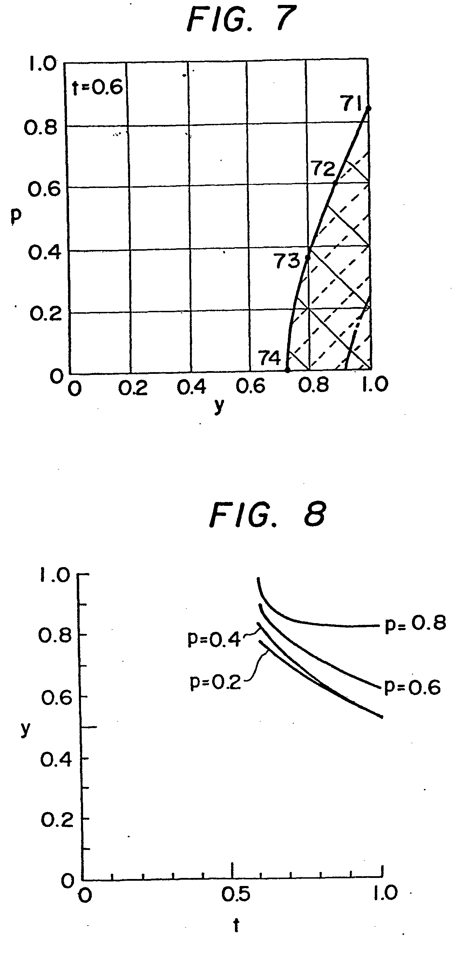

Fig. 8 shows the relationship of y, t and p, already illustrated in Figs. 3 to 7, in another way. The curves are the lower limits of y in dependence on t, for various values of p as indicated.

In order to match the lattice constants, the following formulae should be satisfied:

$$| q - q_0 | \leqq \Delta q \qquad (4)$$

and

$$q_0 = \frac{a - 5.4625 + 0.013p}{0.198 + 0.0044p} \qquad (5)$$

In the above formulae, $\Delta p$ is an allowance for non-matching and empirically is up to 0.02. q is selected within the range 0 to 10. The same applies for q'.

The band gap Eg of the active layer is represented by the following formula:

$$Eg = 1.35 - x + 1.4y - 0.33 \ x \ y$$
$$- (0.738 - 0.28x) \ y \ (1 - y)$$
$$- (0.101 + 0.109y) \ x \ (1 - x) \qquad (3)$$

4

If the compositions are as described above it can be arranged that the band gaps of the cladding layers are larger by at least 0.1 eV than the band gap of the active layer 1 and also that the device is operable continuously at room temperature. Furthermore, in the regions defined in Figs. 3 to 7 by the chain-dot lines and the coordinate axes (i.e. the regions below and to the right of the chain-dot lines) this band gap difference can be made larger than 0.3 eV.

The following advantages may be obtained when the difference between the band gap of the cladding layers and the band gap of the active layer is at least 0.3 eV:—

(1) The threshold current value can be remarkably reduced. Thus when this band gap difference is 0.3 eV, the threshold current value is about 1/3 of its value when the band gap difference is 0.1 eV.

(2) The stability of the threshold current density (Jth) to ambient temperatures can be increased. Generally the threshold current density (Jth) is represented by the following formula:

$$Jth = Joexp(T/To)$$

wherein Jo is a constant and T is the ambient temperature ($^\circ$K).

The value of To varies depending on the above-mentioned band gap difference between the cladding layers and the active layer. If this band gap difference is 0.1 eV, To lies in the range 30—50$^\circ$K; if it is 0.3 eV, To lies in the range 80—150$^\circ$K. The temperature characteristic of Jth is stabilized according to the value of To.

For ease of operation, it is preferred that the compositions of the two cladding layers sandwiching the active layer are the same, but of course, different compositions may be used.

Preferably the thickness of the active layer is 0.05 to 3.0 $\mu$m, more preferably 0.1 to 1.0 $\mu$m, and the thickness of each cladding layer is 0.05 $\mu$m to about 50 $\mu$m, preferably 1 to $\mu$m.

Several examples of the laser device of Fig. 1 will now be given. In these, as is usually suitable in practice, $p > 0.6$. The layer 2, the layer 1, the layer 3 and a layer 7 of $GaAs_tP_{1-t}$, are formed in sequence on the substrate 4 which has the plane (100) as its upper surface, by a known liquid phase epitaxial method using a slide boat. A semiconductor substrate having its plane (111) as its upper surface can alternatively be used.

The solution for growth of the GaAlAsP layer is formed by adding GaAs, Al and GaP to a Ga solution. The amounts of these components added are adjusted so that the desired composition is formed. The solution for growth of the GaInAsP layer is likewise formed by adding GaAs, Ga and GaP to an In solution, and the solution for growth of GaAsP layer is formed by adding GaAs and GaP to a Ga solution. The temperatures of these solutions are raised to about 750$^\circ$C and while they are cooled at a rate of 0.1 to 1$^\circ$C/min, the substrate is contacted with them in sequence.

The compositions of the respective layers in the three different samples are shown in Table 3.

TABLE 3

| Sample No. | | Compositions | Dopant | Thick-ness ($\mu$m) | Oscillation Wave Length (nm) |
|---|---|---|---|---|---|
| 1 | layer 2 | $Ga_{0.34}Al_{0.66}As_{0.86}P_{0.14}$ | Te | 3 | 689 |
| | layer 1 | $Ga_{0.7}In_{0.3}As_{0.28}P_{0.72}$ | un-doped | $\sim 0.2$ | |
| | layer 3 | $Ga_{0.34}Al_{0.66}As_{0.86}P_{0.14}$ | Zn | 3 | |
| | layer 7 | $GaAs_{0.9}P_{0.1}$ | Te | 1 | |
| | layer 4 | $GaAs_{0.9}P_{0.1}$ | Te | 100 | |
| 2 | layer 2 | $Ga_{0.18}Al_{0.82}As_{0.7}P_{0.3}$ | Te | 3 | 620 |
| | layer 1 | $Ga_{0.72}In_{0.28}As_{0.16}P_{0.84}$ | undoped | $\sim 0.2$ | |
| | layer 3 | $Ga_{0.18}Al_{0.82}As_{0.7}P_{0.3}$ | Zn | 3 | |
| | layer 7 | $GaAs_{0.74}P_{0.26}$ | Te | 1 | |
| | layer 4 | $GaAs_{0.74}P_{0.26}$ | Te | 100 | |
| 3 | layer 2 | $Ga_{0.32}Al_{0.68}As_{0.56}P_{0.44}$ | Te | 3 | 620 |
| | layer 1 | $Ga_{0.89}In_{0.11}As_{0.35}P_{0.65}$ | undoped | $\sim 0.2$ | |
| | layer 3 | $Ga_{0.32}Al_{0.68}As_{0.56}P_{0.44}$ | Zn | 3 | |
| | layer 7 | $GaAs_{0.6}P_{0.4}$ | Te | 1 | |
| | layer 4 | $GaAs_{0.6}P_{0.4}$ | Te | 100 | |

After the process steps described above, an $Al_2O_3$ layer for example is formed on the top face of the GaAsP layer 7 so as to leave a window of predetermined shape having a width of 5 $\mu$m. Zn is diffused through this window to form a Zn-diffused region 8. The width of this stripe region 8 may be 1 to 20 $\mu$m, as in conventional devices. After removal of the $Al_2O_3$ film, Au and Cr is vacuum deposited as a positive electrode 6 and Au-Ge-Ni alloy as negative electrode 5. The structure is cleft in the plane (110) to obtain parallel end planes which form reflection planes for oscillation. The cavity length is 300 $\mu$m.

Oscillation at room temperature is possible in each of samples 1, 2 and 3. The threshold current density is 5 to 7 $kA/cm^2$.

As can be seen from the data shown in Table 3, in devices of the present invention, oscillation can be obtained in a short wavelength region in which it is impossible in conventional laser devices.

The cladding layers sandwiching the active layer may be asymmetric relative to each other in respect of their thickness and the like. Moreover, the arrangement of the n- and p-types may be reverse to that of the above embodiments. In these embodiments the active layer is undoped, but it may be doped with impurity, if desired, and in this case also, the desired object of the present invention may be attained.

Characteristically, the devices of the present invention have a double-hetero structure and are capable of oscillation in a short wavelength region. Various modifications can be made to stabilize the laser oscillation. For example, the following can be mentioned.

In a simple double-hetero structure, the refractivity varies in the longitudinal direction (the direcion perpendicular to the hetero junction face) but in the lateral direction (the direction parallel to the hetero junction face) there is no change of refractivity. Alternatively, mesa etching may be conducted on the crystal surface parallel to the hetero-junction face of the double-hetero structure, to form a stripe-like mesa structure acting as the operative region. It is preferred that this mesa structure is covered at its sides by a semiconductor layer having a refractivity lower than that of the active region.

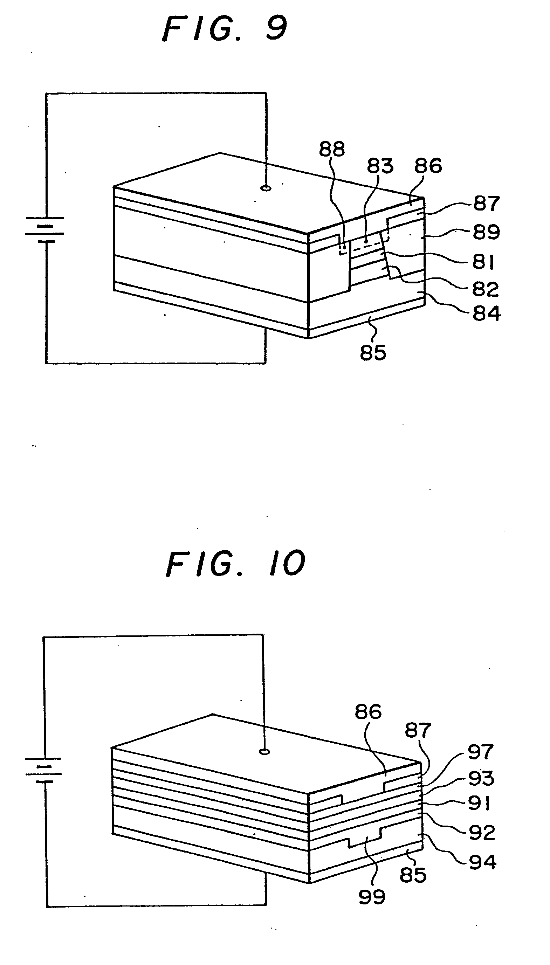

An example of this is illustrated in Fig. 9 The device has a substrate 84 of GaAsP as in previous embodiments, a first conductivity type layer 82 of $Ga_pAl_{1-p}As_qP_{1-q}$ ($0 \leqq p \leqq 0.91$ and $0.47 \leqq q \leqq 1.0$), an active layer 81 of $Ga_yIn_{1-y}As_xP_{1-x}$ ($0.52 \leqq y \leqq 1.0$ and $0 \leqq x \leqq 1.0$), and a layer 83 of conductivity type opposite to that of the layer 82 and composed of $Ga_{p'}Al_{1=p'}As_{q'}P_{1-q'}$ ($0 \leqq p' \leqq 0.91$ and $0.47 \leqq q' \leqq 1.0$). The double-hetero structure is constituted by these layers. The layers 82, 81 and 83 are grown on the substrate 84 by liquid phase epitaxy method, and etching is performed so that a desirable mesa stripe width is obtained. Then, layers 89 of $Ga_{p''}Al_{1-p''}As_{q''}P_{1-q''}$ ($0 \leqq p'' \leqq 0.91$ and $0.47 \leqq q'' \leqq 1.0$) are grown to sandwich the strip-like double hetero structure at both sides. Positive and negative poles 85 and 86 are formed by vacuum deposition of metals. An apertured insulating layer 87 of $SiO_2$ or the like is provided and a Zn-diffused layer 88 is formed by diffusing Zn through the window of the insulating layer 87. With this structure in which an operative region having a high refractivity is embedded in a layer having a low refractivity, there can be obtained a semiconductor laser device in which optical transmission, laser oscillation or optical modulation can be performed with good characteristics and with low loss.

An alternative modification for stabilizing laser oscillation is illustrated by Fig. 10. Here, a light-absorbing member is formed on each of the two sides of a predetermined stripe portion of a layer sandwiching the active layer so that loss on both sides of the stripe is increased and expansion of the lateral mode is prevented. Furthermore, a change of the refractivity i.e. the effective complex refractive index is produced at both sides of the stripe. By variation of the effective complex refractive index in the lateral direction, expansion of the lateral mode can be prevented.

In the device of Fig. 10 in particular, an elongate groove of predetermined width, for example about 10μm, is formed on a GaAsP substrate 94. Then, a first cladding layer 92 of $Ga_pAl_{1-p}As_qP_{1-q}$ ($0 \leqq p \leqq 0.91$ and $0.47 \leqq q \leqq 1.0$), an active layer 91 of $Ga_yIn_{1-y}As_xP_{1-x}$ ($0.52 \leqq y \leqq 1.0$ and $0 \leqq x \leqq 1.0$), a layer 93 of the conductivity type opposite to that of the first layer 92 and composed of $Ga_{p'}Al_{1-p'}As_{q'}P_{1-q'}$ ($0 \leqq p' \leqq 0.91$ and $0.47 \leqq q' \leqq 1.0$), and a layer 97 of GaAs are successively grown on the substrate 94. In this structure, light leaking from the two sides of the stripe 99 of the layer 91 which fills the groove in the substrate 94 arrives at the GaAsP substrate i.e. the effective complex refractive index varies, so that expansion of the lateral mode can be prevented. The groove which leads to the formation of the stripe 99 may be formed by first forming a layer on the substrate 94 and then removing a portion having a width corresponding to the stripe width, to form a mask. Etching is then performed with a solution of phosphoric acid, hydrogen peroxide and ethylene glycol. This arrangement for causing a change of the effective complex refractive index may alternatively be in the second cladding layer, or in both of the first and second cladding layers.

## Claims

1. A semiconductor laser device comprising a semiconductor substrate (4) and above the substrate a semiconductor active layer (1) and two semiconductor cladding layers (2, 3), said active layer (1) providing an optical confinement region having a higher refractivity than that of each said cladding layer and a band gap narrower than that of each said cladding layer, characterised in that the substrate (4) is composed of $GaAs_tP_{1-t}$ ($0.54 \leqq t < 1.0$), and above the substrate (4) in sequence are a first said cladding layer (2) of a first conductivity type composed of $Ga_pAl_{1-p}As_qP_{1-q}$ ($0 \leqq p \leqq 0.91$ and $0.47 \leqq q \leqq 1.0$), the said active layer (1) which is composed of $Ga_yIn_{1-y}As_xP_{1-x}$ ($0.52 \leqq y \leqq 1.0$ and $0 \leqq x \leqq 1.0$) and a second said cladding layer (3) of a conductivity type opposite to said first conductivity type and composed of $Ga_{p'}Al_{1-p'}As_{q'}P_{1-q'}$ ($0 \leqq p' \leqq 0.91$ and $0.47 \leqq q' \leqq 1.0$).

2. A semiconductor laser device according to claim 1 wherein the thickness of said active layer (1) is in the range 0.05 to 3.0 μm.

3. A semiconductor laser device according to claim 1 or claim 2 wherein the difference between

7

the band gap of the active layer (1) and the band gaps of the cladding layers (2, 3) is in each case at least 0.3 eV.

## Patentansprüche

1. Halbleiterlaser, umfassend ein Halbleitersubstrat (4) sowie auf dem Substrat eine aktive Halbleiterschicht (1) und zwei Halbleiter-Einhüllschichten (2, 3), wobei die aktive Schicht (1) einen optischen Eingrenzungsbereich bildet, der einen höheren Brechungsindex und einen geringeren Bandabstand aufweist als jede der Einhüllschichten, dadurch gekennzeichnet, daß das Substrat (4) aus $GaAs_tP_{1-t}$ (mit $0,54 \leqq t < 1,0$) besteht und auf dem Substrat 4) der Reihe nach eine erste (2) der Einhüllschichten eines ersten Leitungstyps, bestehend aus $Ga_pAl_{1-p}As_qP_{1-q}$ (mit $0 \leqq p \leqq 0,91$ und $0,47 \leqq q \leqq 1,0$), die aktive Schicht (1), die aus $Ga_yIn_{1-y}As_xP_{1-x}$ (mit $0.52 \leqq y \leqq 1,0$ und $0 \leqq x \leqq 1,0$) und eine zweite (3) der Einhüllschichten eines zu dem ersten Leitungstyp entgegengesetzten zweiten Leitungstyps, bestehend aus $Ga_{p'}Al_{1-p'}As_{q'}P_{1-q'}$ (mit $0 \leqq p' \leqq 0,91$ und $0,47 \leqq q' \leqq 1,0$), angeordnet sind.

2. Halbleiterlaser nach Anspruch 1, wobei die Dicke der aktiven Schicht (1) im Bereich von 0,05 bis 3,0 $\mu$m liegt.

3. Halbleiterlaser nach Anspruch 1 oder 2, wobei der Unterschied zwischen dem Bandabstand der aktiven Schicht (1) und den Bandabständen der Einhüllschichten (2, 3) jeweils mindestens 0,3 eV beträgt.

## Revendications

1. Dispositif laser à semiconducteurs, comportant un substrat semiconducteur (4) et, au-dessus de ce dernier, une couche semiconductrice active (1) et deux couches semiconductrices de revêtement (2, 3), ladite couche active (1) formant une région de confinement optique possédant une réfringence supérieure à celle de chaque couche de revêtement et une bande interdite plus étroite que chacune des couches revêtement, caractérisé en ce que le substrat (4) est composé de $GaAs_tP_{1-t}$ ($0,54 \leqq t < 1$), et qu'au-dessus du substrat (4) sont disposées successivement une première (2) desdites couches de revêtement, possédant un premier type de conductivité et constituée par du $Ga_pAl_{1-p}As_qP_{1-q}$ ($0 \leqq p \leqq 0,91$ et $0,47 \leqq q \leqq 1$), ladite couche active (1) qui est constituée de $Ga_yIn_{1-y}As_xP_{1-x'}$ ($0,52 \leqq y \leqq 1$ et $0 \leqq x \leqq 1$) et la seconde (3) desdites couches de revêtement, possédant un type de conductivité opposé audit premier type de conductivité et constituée de $Ga_{p'}Al_{1-p'}As_{q'}P_{1-q'}$ ($0 \leqq p' \leqq 0,91$ et $0,47 \leqq q' \leqq 1$).

2. Dispositif laser à semiconducteurs selon la revendication 1, caractérisé en ce que l'épaisseur de la couche active (1) se situe dans la gamme comprise entre 0,05 et 3 microns.

3. Dispositif laser à semiconducteurs selon l'une des revendications 1 ou 2, caractérisé en ce que les différences entre la bande interdite de la couche active (1) et les bandes interdites des couches de revêtement (2, 3) est égale, dans tous les cas, à au moins 0,3 eV.

# FIG. 1

# FIG. 2

## FIG. 3

## FIG. 4

## FIG. 5

## FIG. 6

## FIG. 7

## FIG. 8

4

# FIG. 9

88  83  86
87
89
81
82
84
85

# FIG. 10

86  87
97
93
91
92
94
85
99